# EUROPÄISCHE PATENTSCHRIFT

(11) **EP 1 604 385 B1**
(45) Veröffentlichungstag und Bekanntmachung des Hinweises auf die Patenterteilung: **11.12.2019**
(21) Anmeldenummer: 04710788.3
(22) Anmeldetag: 13.02.2004
(51) Int. Cl.: H01L 31/0203, H01L 33/48, H01L 23/057, H01L 23/00, H01L 25/16, H01L 33/62

(54) **OPTOELEKTRONISCHES BAUELEMENT MIT EINEM GEHÄUSEKÖRPER AUS KUNSTSTOFFMATERIAL**
OPTOELECTRONIC DEVICE WITH HOUSING BODY MADE OF A PLASTIC MATERIAL
COMPOSANT OPTOÉLECTRONIQUE AVEC UN CORPS DE BOITIER EN MATIÈRE PLASTIQUE

(30) Priorität: 10.03.2003 DE 10310619; 11.03.2003 DE 10310844
(43) Veröffentlichungstag der Anmeldung: 14.12.2005
(73) Patentinhaber: OSRAM Opto Semiconductors GmbH, 93055 Regensburg (DE)
(72) Erfinder: BRUNNER, Herbert, 93161 Sinzing (DE); HÖFER, Thomas, 93059 Lappersdorf (DE); KRÄUTER, Gertrud, 93051 Regensburg (DE); ZEILER, Markus, 93152 Nittendorf (DE)
(74) Vertreter: Zacco Patent- & Rechtsanwälte
(86) Internationale Anmeldenummer: PCT/DE2004/000271
(87) Internationale Veröffentlichungsnummer: WO 2004/081972

(56) Entgegenhaltungen:
- EP-A- 0 322 165
- EP-A2- 1 249 874
- WO-A-01/96458
- DE-A1- 10 117 890
- JP-A- 10 190 173
- JP-A- 2001 335 708
- JP-A- 2001 339 143
- US-A1- 2002 089 047
- US-A1- 2003 052 420
- DATABASE INSPEC [Online] THE INSTITUTION OF ELECTRICAL ENGINEERS, STEVENAGE, GB; "Mechanism of creep-path formation" XP002317400 Database accession no. 1943B01196 & PLASTICS, Januar 1943 (1943-01), Seiten 9-14, USA
- PATENT ABSTRACTS OF JAPAN Bd. 010, Nr. 079 (E-391), 28. März 1986 (1986-03-28) & JP 60 225482 A (TOSHIBA KK), 9. November 1985 (1985-11-09)

## Beschreibung

Die Erfindung betrifft ein optoelektronisches Bauelement mit einem Gehäusekörper.

Silber besitzt in der Elektroindustrie eine zentrale Stellung bei der Verwendung für elektrische Kontakte. In der Halbleiterindustrie wird es vor allem in der Form von Beschichtungen und silbergefüllten Leitklebern eingesetzt. Für diesen Einsatz prädestiniert Silber eine Reihe von Vorteilen, wie seine gute Verarbeitbarkeit, hohe Duktilität, hohe elektrische und thermische Leitfähigkeit und ein relativ niedriger Preis, vor allem im Vergleich zu den ebenso in der Elektroindustrie eingesetzten teuren Edelmetallen, wie Gold und Palladium.

Probleme mit Silber treten jedoch vor allem dann auf, wenn es in Kombination mit herkömmlich verwendeten Kunststoffen, wie glasfasergefüllten Thermoplastmaterialien vorliegt. Silber hat vor allem in Form seiner Ionen eine hohe Beweglichkeit in solchen Kunststoffen. Besonders in Thermoplasten, jedoch auch - wenn auch in geringerem Maße - in Duroplasten, wandert Silber in elektrischen Feldern entlang der Feldlinien. Dies kann zu einer unerwünschten und die Funktionalität des Bauelements schädigenden Verarmung oder Anreicherung von Silber im Gehäusekörper führen.

Insbesondere bei strahlungsaussendenden und/oder -empfangenden Halbleiterbauelementen liegt häufig ein Kunststoffgehäusekörper vor, der sich - gewolltermaßen oder ungewollt - in direktem Kontakt mit metallischen Teilen, insbesondere mit einem silberhaltigen oder silberbeschichteten Träger oder einem silbergefüllten Leitkleber befindet. Hierbei besteht die Gefahr, daß bei Anliegen einer Spannung, die ein elektrisches Feld im Gehäusekörper erzeugt, Silber von dem Träger oder dem Leitkleber in den Kunststoffgehäusekörper migriert. Die Migration setzt sich in dem Kunststoffgehäusekörper fort. Diese Migration kann mit fortschreitender Zeit dazu führen, daß zwischen zwei elektrischen Anschlüssen ein elektrisch leitender Pfad innerhalb des Kunststoffs entsteht, der zu Fehlströmen, im schlimmsten Fall zum elektrischen Kurzschluß zwischen den beiden elektrischen Anschlüssen führen kann.

Ist der Kunststoff, beispielsweise ein Thermoplast, mit Fasern, wie beispielsweise Glasfasern, mechanisch verstärkt, tritt insbesondere das Problem auf, daß die Metallionen verstärkt entlang der Fasern wandern und dadurch die Migration beschleunigt wird.

Dieses Migrationsproblem, das bei Silber besonders ausgeprägt ist, liegt aber auch - wenn auch in geringerem Umfang - bei anderen Metallen, wie Kupfer und Nickel vor. Weiterhin existieren Leitkleber, die mit silberbeschichteten Kupferkugeln versetzt sind, wodurch das grundlegende Problem der Silbermigration wegen der geringeren Gesamtmenge an Silber zwar verringert ist, aber dennoch existiert.

Die Migration von Metallionen, insbesondere von Silberionen, in (insbesondere glasfaserverstärkten) Thermoplastmaterialien, tritt verstärkt bei erhöhter Luftfeuchtigkeit, erhöhter Umgebungstemperatur und/oder einer am Bauteil anliegenden hohen Spannung auf. Silberionen von beispielsweise Leadframeoberflächen oder von Kleberfüllstoff migrieren beispielsweise entlang von elektrischen Feldlinien eines anliegenden elektrischen Feldes durch den Kunststoff, beispielsweise PPA. Beispielsweise ein Glasfaserfüllstoff begünstigt die SilberMigration.

Durch Verwendung von Gold anstelle von Silber wird zwar einerseits die Gefahr einer schädigenden Metallmigration verringert, jedoch entstehen andererseits dadurch erhöhte Bauteil-Kosten.

Die Druckschriften JP 2001 335708A und EP-A-0 322 165 beschreiben jeweils ein Gehäusematerial aus einem mit Füllstoff versehenen Kunststoffmaterial für ein Halbleiterbauelement.

Die Druckschriften JP 2001 339143 A und JP 10 190173 A beschreiben jeweils Leiterplatten sowie mit Füllstoff versehene Kunststoffmaterialien zur Bildung dieser Leiterplatten.

Die Druckschrift US 2002/089047 A1 beschreibt ein optoelekttronisches Bauelement.

Die Druckschrift DE 101 17 890 A1 offenbart ein strahlungsempfangendes und/oder -emittierendes Halbleiterbauelement.

Die Druckschrift EP 1 249 874 A2 betrifft eine lichtemittierende Einrichtung mit einem Kunststoffkörper der mit einem Füllstoff aus hochreflektierendem Material versehen ist.

Der Erfindung liegt die Aufgabe zugrunde ein strahlungsaussendendes und/oder -empfangendes Bauelement mit einem Gehäusekörper zu schaffen, der es erlaubt, im Bauelement ein zur Migration neigendes Metall, wie Silber bzw. Silberionen, zu verwenden, ohne gleichzeitig das Risiko einer raschen Schädigung des Bauelements durch Migration dieses Metalls drastisch zu erhöhen.

Aufgabe ist es insbesondere weiterhin, ein strahlungsaussendendes und/oder -empfangendes Bauelement zur Verfügung zu stellen, das einen Leiterrahmen besitzt, der mit Silber oder einem anderen in einem elektrischen Feld in Kunststoff zur Migration neigenden Metall beschichtet ist und der mit einem Gehäusekörper zumindest teilweise umschlossen ist, und im Gehäusekörper die Migration des Metalls im Kunststoff unterbunden oder zumindest stark behindert wird.

Diese Aufgaben werden durch ein Bauelement mit den Merkmalen des Anspruchs 1 gelöst.

Bei einem Bauelement mit einem Gehäusekörper gemäß der Erfindung ist das Kunststoffmaterial mit Füllstoffpartikeln versetzt, die eine Migration von Metall und/oder Metallionen im Kunststoffmaterial unterbinden oder zumindest stark behindern. Gemäß der Erfindung sind dies kugelartige Füllstoffpartikel.

Die Füllstoffpartikel nach der Erfindung besitzen nicht wie Glasfasern eine beschleunigende Wirkung für die Migration von Metallionen im elektrischen Feld, sondern hemmen diese vielmehr deutlich.

Als Füllstoffpartikel werden in diesem Zusammenhang alle Füllstoffe genannt, deren primäre Aufgabe in einem erfindungsgemäßen Kunststoffgehäuse es ist, die Migration von Metall oder Metallionen in Kunststoff zu unterbinden oder zumindest stark zu behindern.

Das Problem der Migration von Silber und/oder Silberionen und anderen Metallen und/oder Metallionen tritt zwar in erster Linie in wesentlichem Maße in Thermoplasten auf, kann aber grundsätzlich ebenso in Duroplasten auftreten, wo es ebenfalls zu schädlichen Wirkungen führen kann.

In einer bevorzugten Ausführungsform ist ein metallischer Leiterrahmen (Leadframe) mit einem Gehäusekörper umformt. Dieser ist vorzugsweise mittels eines Spritzgießverfahrens oder mittels eines Spritzpressverfahrens hergestellt. Solche Bauformen werden auch als sogenannte Premold-Bauformen bezeichnet. Besonders bevorzugt umschließt der Gehäusekörper zumindest einen Teil des Leiterrahmens vollständig. Dadurch wird eine technisch stabile Verbindung zwischen Gehäusekörper und Leiterrahmen erzielt.

Besonders bevorzugt wird ein elektrischer Leiterrahmen eingesetzt, der ein Metall enthält oder mit einem Metall beschichtet ist, dessen Migrationsneigung in Kunststoff hoch ist. In einem solchen Fall ist die Grenzfläche zwischen Leiterrahmenoberfläche und Gehäusekörper, über die Metall und/oder Metallionen in den Gehäusekörper wandern können, vergleichsweise groß.

Eine weitere oder andere Quelle für im Kunststoff migrierende Metallatome und/oder Metallionen kann ein metallgefüllter Leitkleber sein, mit dem beispielsweise der Chip in dem Gehäusekörper auf einem Leiterrahmen oder auf einer Leiterbahn befestigt ist. Ein solcher Leitkleber dient dazu, eine elektrische Verbindung zwischen dem Chip und dem Leiterrahmen bzw. der Leiterbahn bei gleichzeitiger mechanischer Verbindung herzustellen. Zwischen Chip und Leiterbahn oder Leiterrahmen herausgequollener Leitkleber kann mit dem Gehäusekörper in direkten Kontakt geraten, so daß Metallatome oder Metallionen vom Leitkleber in das Material des Gehäusekörpers übertreten können. Diese Problematik gewinnt besonders bei den immer kleiner werdenden Bauformen immer mehr an Bedeutung. Erfindungsgemäße Gehäusekörper sind für solche Bauformen besonders geeignet.

Besonders geeignet sind erfindungsgemäße Gehäusekörper dort wo im Bauelementgehäuse Silber zum Einsatz kommt. Aufgrund der starken Migrationsneigung von Silber insbesondere in Thermoplastmaterial und besonders bei Einwirkung eines elektrischen Feldes ist seine Verwendung bislang stark begrenzt. Silber ist aber aufgrund seines gegenüber Gold, Platin oder Palladium viel niedrigeren Preises ein wünschenswertes Kontaktmetall. Analoges gilt für Kupfer und Nickel.

In einer nicht zur Erfindung gehörenden Ausführungsform weisen die Füllstoffpartikel eine plättchenartige Form auf. Eine relativ stochastische Verteilung solcher Partikel erschwert bereits aus geometrischen Gründen eine Migration im Gehäusekörper. Auch bei texturierter Verteilung ist eine Wanderung in einem Winkel um 90° zur Ebene der Plättchen stark behindert. Plättchenförmige Füllstoffpartikel haben weiterhin den Vorteil, daß sie wegen ihres hohen Längen-zu-Dicken-Verhältnisses ähnlich wie Kurzfasern zu einer mechanischen Verstärkung des Kunststoffs im Gehäusekörper beitragen.

In einer bevorzugten Ausführungsform gemäß der Erfindung werden als Füllstoffpartikel Glaskügelchen verwendet.

Vorteilhafterweise können mit den Füllstoffpartikeln die mechanischen Eigenschaften, wie Zugfestigkeit, E-Modul, Schlagzähigkeit des Gehäusekörpers gezielt eingestellt werden.

Besonders geeignet ist ein Gehäusekörper gemäß der Erfindung bei Bauelementen mit mindestens einem Photodetektorchip. Solche Chips werden mit höhen Sperrspannungen betrieben, so dass zwischen den elektrischen Anschlüssen am oder im Gehäusekörper starke elektrische Felder herrschen. Analoges gilt für Bauelemente mit einer Mehrzahl von strahlungsemittierenden Chips, wenn diese beispielsweise auf stark unterschiedlichen Potentialen liegen.

In einer weiteren Variante des erfindungsgemäßen Gehäusekörpers weist das Gehäusematerial zusätzlich zu den Füllstoffpartikeln Streupartikel auf. Diese Streupartikel bewirken, daß der Gehäusekörper zumindest weitgehend undurchsichtig ist und einen hohen diffusen Reflexionsgrad besitzt. Bevorzugt weisen die Streupartikel Titandioxid auf.

Als ein besonders bevorzugtes Material für einen Gehäusekörper, insbesondere von vorzugsweise Leadframe-basierten optoelektronischen Bauelementen, weist der Gehäusekörper Polyphthalamid (PPA) auf. Solche Thermoplastmaterialien lassen sich effektiv spritzpressen oder spritzgießen. Außer PPA lassen sich auch andere, vorteilhafterweise in der Gehäusetechnik herkömmlich verwendete Thermoplastmaterialien einsetzen.

Weitere Vorteile, vorteilhafte Ausführungsformen und Weiterbildungen ergeben sich aus den im folgenden in Verbindung mit den Figuren 1 bis 3 erläuterten Ausführungsbeispielen.

Es zeigt:
Fig. 1 eine schematische Darstellung eines Schnittes durch ein erstes Ausführungsbeispiel,
Fig. 2 eine schematische Darstellung eines Schnittes durch ein zweites Ausführungsbeispiel, und
Fig. 3 eine schematische Darstellung eines Schnittes durch einen Gehäusekörper ohne erfindungsgemäße Füllstoffpartikel.

In den verschiedenen Ausführungsbeispielen sind gleiche oder gleichwirkende Bestandteile jeweils gleich bezeichnet und mit den gleichen Bezugszeichen versehen.

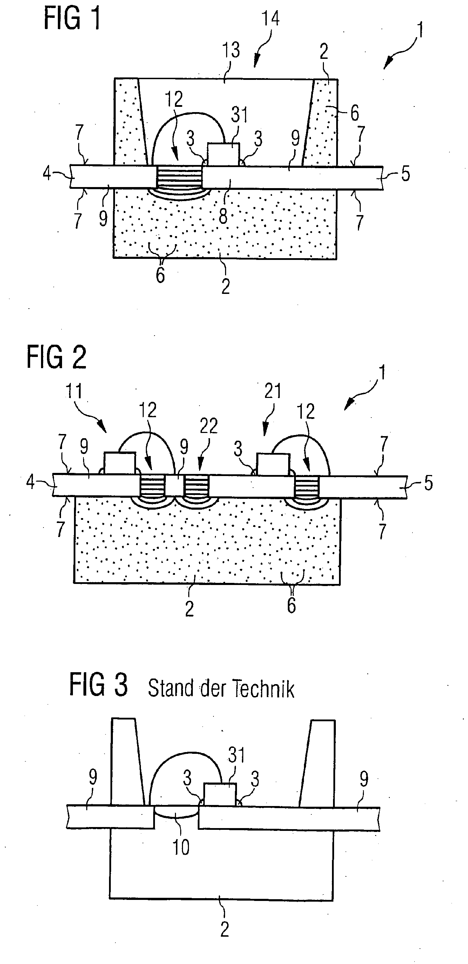

Bei dem Ausführungsbeispiel gemäß Figur 1 handelt es sich um ein Halbleiter-Detektor-Bauelement 1 mit einem Gehäusekörper 2 aus Thermoplastmaterial, hier beispielsweise PPA, der um -einen elektrischen Leiterrahmen 9 aus Metall gespritzt ist. Der Leiterrahmen 9 ist mit einer Silberbeschichtung 7 versehen und von dem Gehäusekörper 2 teilweise umschlossen. Der Gehäusekörper 2 ist beispielsweise spritzgegossen oder spritzgepresst. Auf einem Chipträgerteil 8 des Leiterrahmens 9 ist mit einem silbergefüllten Leitkleber 3 ein DetektorChip 31 aufgebracht. In einem nicht zur Erfindung gehörenden Ausführungsbeispiel ist das Thermoplastmaterial des Gehäusekörpers 2 mit plättchenartigen Füllstoffpartikeln 6 aus Kaolin (mittlere Größe beispielsweise ca. 3 *µ*m) versetzt, die eine Migration von Silber aus der Beschichtung 7 des Leiterrahmens 9 bzw. aus dem Leitkleber 3 unterbinden oder zumindest stark behindern.

Statt Silber kann sich auch ein anderes, zur Migration in Kunststoff neigendes Metall auf dem Leiterrahmen 9 und/oder in dem Leitkleber 3 befinden, wie z.B. Nickel oder Kupfer.

Anstelle von Kaolin-Füllstoff kann ein anderes Pulver, bevorzugt ein nicht-metallisches Pulver, wie ein keramisches oder mineralisches Pulver eingesetzt sein. Ebenso ist, gemäß einer Ausführungsform der Erfindung, die Verwendung von Glaskügelchen als Füllstoffpartikel 6 möglich.

Außer den Füllstoffpartikeln, die eine Migration von Metall in dem Kunststoff des Gehäusekörpers 2 verhindern, können sich noch andere Stoffe in dem Kunststoff befinden, wie beispielsweise TiO₂ oder ähnliche Streupartikel, die dazu beitragen, daß der Gehäusekörper undurchsichtig ist und einen hohen diffusen Reflexionsgrad von beispielsweise 80 % besitzt.

Der Gehäusekörper kann, wie oben genannt, aus Polyphthalamid bestehen, aber auch aus jedem anderen Thermoplastmaterial, das die für einen Gehäusekörper 2 notwendigen Eigenschaften, wie beispielsweise mechanische und thermische Stabilität besitzt.

Der Leiterrahmen 9 weist zwei oder mehr externe Anschlußteile 4, 5 auf, die aus dem Gehäusekörper 2 ragen. Der Gehäusekörper 2 besitzt eine Reflektor-Ausnehmung 14, in der der Chip 31 angeordnet ist. Die Reflektor-Ausnehmung 14 ist mit einem strahlungsdurchlässigen Fensterteil 13 gefüllt.

Eine Migration von Silber in einem elektrischen Feld 12, das im Betrieb des Bauelements zwischen den beiden Leiterrahmenteilen herrscht, wird durch die Kaolin-Partikel unterbunden bzw. stark behindert. Es kommt nicht oder erst nach hinreichend langer Betriebsdauer des Bauelements 1 zu störenden Kriechströmen zwischen den beiden Leiterrahmenteilen.

Das Ausführungsbeispiel gemäß Figur 2 unterscheidet sich von dem vorangehend beschriebenen Ausführungsbeispiel insbesondere dadurch, daß das Bauelement zwei Halbleiterchips, beispielsweise einen Detektorchip und einen Emitterchip, zwei Emitterchips oder zwei Detektorchips, aufweist, die im Betrieb des Bauelements auf stark unterschiedlichem Potential liegen.

Im Betrieb herrschen zwischen den Anschlußteilen des Leiterrahmens elektrische Felder 12,22, die eine Metall-Migration im Gehäusekörper beschleunigen würden. Auch in diesem elektrischen Feld wird in einer nicht zur Erfindung gehörenden Ausführungsform durch die plättchenartigen Kaolin-Füllstoffpartikel 6 eine Metallmigration unterbunden oder zumindest hinreichend stark behindert.

Das Bauelement gemäß Figur 3 weist einen herkömmlichen Gehäusekörper auf, der keine erfindungsgemäßen Füllstoffpartikel, sondern Glasfasern enthält. Ein Detektorchip 31 ist mit silberhaltigem Leitkleber 3 auf den Leiterrahmen 9 befestigt und der Leitkleber ist in direktem Kontakt mit dem Gehäusekörper 2. Nach einer gewissen Betriebszeit kann sich aufgrund von Silbermigration zwischen den beiden voneinander getrennten Leiterrahmenteilen im Gehäusekörper 2 ein elektrisch leitender Pfad 10 ausbilden, der im schlimmsten Fall zu einem Totalausfall des Bauelements führen kann.

Die Erfindung ist selbstverständlich nicht auf die konkret beschriebenen Ausführungsbeispiele beschränkt. Insbesondere ist sie für Gehäusekörper unterschiedlicher Geometrie einsetzbar. Ein optoelektronisches Bauelement mit einem Gehäusekörper gemäß der Erfindung verhindert auf einfache Weise die Migration von Metall in dem Gehäusekörper weitgehend und kann die Verwendung von teurem Kontaktmaterial wie Gold vermeiden.

Der Schutzumfang der Erfindung ist nicht durch die Beschreibung der Erfindung anhand der Ausführungsbeispiele sondern nur durch die Patentansprüche beschränkt.

## Patentansprüche

1. Optoelektronisches Bauelement (1) mit
- einem Gehäusekörper (2) der zumindest teilweise aus einem Kunststoffmaterial gefertigt ist,
- mindestens einem eine elektromagnetische Strahlung aussendenden und/oder empfangenden Chip (31), der auf mindestens einem Chipträgerteil (8) eines Leiterrahmens (9) befestigt ist, wobei der Leiterrahmen (9) mindestens zwei externe elektrische Anschlußteile (4, 5) aufweist, die elektrisch leitend mit dem Chip (31) verbunden sind, wobei
- der Chipträgerteil (8) und Teilbereiche der externen elektrischen Anschlußteile (4, 5) von dem Gehäusekörper (2) umschlossen sind, aus dem die externen elektrischen Anschlußteile (4, 5) herausragen,
- der Gehäusekörper (2) eine Ausnehmung (14) aufweist, in der der Chip (31) auf dem Chipträgerteil (8) angeordnet ist, **dadurch gekennzeichnet, dass**
- das Kunststoffmaterial des Gehäusekörpers (2) mit Füllstoffpartikeln (6) versetzt ist, wobei die Füllstoffpartikel (6) eine kugelartige Form aufweisen, und
- die Füllstoffpartikel eine Migration von Silber in einem elektrischen Feld (22, 12) zwischen den Anschlußteilen (4, 5) im Kunststoffmaterial hemmen.

2. Bauelement nach Anspruch 1,
**dadurch gekennzeichnet, daß**
der Chip (31) ein Halbleiter-Photodetektor-Chip ist.

3. Bauelement nach Anspruch 1,
**dadurch gekennzeichnet, daß**
in der Ausnehmung (14) eine Mehrzahl von Chips (31) auf mehreren Chipträgerteilen (8) angeordnet sind, von denen mindestens einer ein Halbleiter-Photodetektor-Chip ist.

4. Bauelement nach Anspruch 1,
**dadurch gekennzeichnet, daß**
in der Ausnehmung (14) eine Mehrzahl von strahlungsemittierenden Chips (31) auf mehreren Chipträgerteilen (8) angeordnet sind.

5. Bauelement nach einem der Ansprüche 1 bis 4,
**dadurch gekennzeichnet, daß**
das Kunststoffmaterial Thermoplastmaterial, insbesondere Polyphthalamid (PPA) aufweist.

6. Bauelement nach einem der Ansprüche 1 bis 5,
**dadurch gekennzeichnet, daß**
der Gehäusekörper (2) an den elektrischen Leiterrahmen (9) mittels Spritzgießen oder Spritzpressen angeformt ist.

7. Bauelement nach einem der Ansprüche 1 bis 6,
**dadurch gekennzeichnet, daß**
der elektrische Leiterrahmen (9) eine Metalloberfläche (7) besitzt oder eine Metallbeschichtung aufweist, die Silber enthält.

8. Bauelement nach einem der Ansprüche 1 bis 7,
**dadurch gekennzeichnet, daß**
mindestens an einem der elektrischen Anschlußteile ein metallgefüllter Leitkleber (3) angeordnet ist, der Silber enthält.

9. Bauelement nach einem der Ansprüche 1 bis 8, **dadurch gekennzeichnet, daß** als die Füllstoffpartikel (6) Glaskügelchen Verwendung finden.

10. Bauelement nach einem der Ansprüche 1 bis 9, **dadurch gekennzeichnet, daß**
mit den Füllstoffpartikeln (6) mechanische Eigenschaften des Gehäusekörpers (2) gezielt eingestellt sind.

## Claims

1. Optoelectronic device (1) with
- a housing body (2) made at least partially of a plastic material,
- at least one chip (31) emitting and/or receiving electromagnetic radiation, attached to at least one chip carrier part (8) of a conductor frame (9), wherein the conductor frame (9) has at least two external electrical connection parts (4, 5), which are electrically conductively connected to the chip (31), wherein
- the chip carrier part (8) and partial regions of the external electrical connection parts (4, 5) are enclosed by the housing body (2), from which the external electrical connection parts (4, 5) project,
- the housing body (2) has a recess (14), in which the chip (31) is arranged on the chip carrier part (8),
**characterized in that**
- the plastic material of the housing body (2) is mixed with filler particles (6), wherein the filler particles (6) have a spherical shape, and
- the filler particles inhibit a migration of silver in an electric field (22, 12) between the connection parts (4, 5) in the plastic material.

2. Device according to claim 1,
**characterized in that**
the chip (31) is a semiconductor photodetector chip.

3. Device according to claim 1,
**characterized in that**
in the recess (14), a plurality of chips (31) is arranged on several chip carrier parts (8), at least one of which is a semiconductor photodetector chip.

4. Device according to claim 1,
**characterized in that**
in the recess (14), a plurality of radiation-emitting chips (31) is arranged on several chip carrier parts (8).

5. Device according to any of claims 1 to 4,
**characterized in that**
the plastic material has thermoplastic material, in particular polyphthalamide (PPA).

6. Device according to any of claims 1 to 5,
**characterized in that**
the housing body (2) is molded onto the electrical conductor frame (9) by means of injection molding or transfer molding.

7. Device according to any of claims 1 to 6,
**characterized in that**
the electrical conductor frame (9) has a metal surface (7) or a metal layer containing silver.

8. Device according to any of claims 1 to 7,
**characterized in that**
a metal-filled conductive adhesive (3) containing silver is arranged at least on one of the electrical connection parts.

9. Device according to any of claims 1 to 8,
**characterized in that** glass beads are used as the filler particles (6).

10. Device according to any of claims 1 to 9,
**characterized in that**
mechanical properties of the housing body (2) are deliberately adjusted with the filler particles (6).

## Revendications

1. Composant optoélectronique (1) avec
- un corps de boîtier (2) constitué au moins partiellement en matériau plastique,
- au moins une puce (31) émettant et / ou recevant un rayonnement électromagnétique, attachée sur au moins une partie de support de puce (8) d'un cadre conducteur (9), ledit cadre conducteur (9) comportant au moins deux pièces de connexion électrique externes (4, 5) connectées électriquement de manière conductrice à la puce (31), dans lequel
- la partie de support de puce (8) et les sous-régions des pièces de connexion électrique externes (4, 5) sont entourées par le corps de boîtier (2) d'où les pièces de connexion électrique externes (4, 5) font saillie,
- le corps de boîtier (2) présente un évidement (14) dans lequel la puce (31) est agencée sur la partie de support de puce (8),
**caractérisé en ce que**
- le matériau plastique du corps de boîtier (2) est mélangé avec des particules de charge (6), les particules de charge (6) ayant une forme sphérique, et
- les particules de charge empêchent une migration d'argent dans un champ électrique (22, 12) entre les pièces de connexion électrique externes (4, 5) dans le matériau plastique.

2. Composant selon la revendication 1,
**caractérisé en ce que**
la puce (31) est une puce à photo-détecteur à semi-conducteur.

3. Composant selon la revendication 1,
**caractérisé en ce que**
dans l'évidement (14) est disposée une pluralité de puces (31) sur plusieurs parties de support de puce (8), dont au moins une est une puce à photo-détecteur à semi-conducteur.

4. Composant selon la revendication 1,
**caractérisé en ce que**
dans l'évidement (14) est disposée une pluralité de puces émettant des radiations (31) sur plusieurs parties de support de puces (8).

5. Composant selon l'une des revendications 1 à 4,
**caractérisé en ce que**
le matériau plastique comprend un matériau thermoplastique, en particulier du polyphtalamide (PPA).

6. Composant selon l'une des revendications 1 à 5,
**caractérisé en ce que**
le corps de boîtier (2) est adapté au cadre électriquement conducteur (9) par moulage par injection ou par transfert.

7. Composant selon l'une des revendications 1 à 6,
**caractérisé en ce que**
le cadre électriquement conducteur (9) présente une surface métallique (7) ou un revêtement métallique contenant de l'argent.

8. Composant selon l'une des revendications 1 à 7,
**caractérisé en ce que**
une colle conductrice chargée de métal (3) contenant de l'argent est disposée sur au moins l'une des pièces de connexion électrique.

9. Composant selon l'une des revendications 1 à 8,
**caractérisé en ce que** des billes de verre sont utilisées en tant que particules de charge (6).

10. Composant selon l'une des revendications 1 à 9,
**caractérisé en ce que**
des propriétés mécaniques du corps de boîtier (2) sont ajustées délibérément grâce aux particules de charge (6).
